# EUROPÄISCHE PATENTANMELDUNG

(11) **EP 2 709 161 A2**
(43) Veröffentlichungstag der Anmeldung: **19.03.2014**
(21) Anmeldenummer: 13181690.2
(22) Anmeldetag: 26.08.2013
(51) Int. Cl.: H01L 31/0236, H01L 31/18

(54) **Verfahren zum zumindest bereichsweisen Einebnen einer Textur einer Halbleiterstruktur**

(30) Priorität: 14.09.2012 DE 102012216408
(71) Anmelder: Fraunhofer-Gesellschaft zur Förderung der angewandten Forschung e.V., 80686 München (DE)
(72) Erfinder: Jäger, Ulrich, 79108 Freiburg (DE); Nekarda, Jan, 79194 Gundelfingen (DE)
(74) Vertreter: Lemcke, Brommer & Partner

(57) **Zusammenfassung**

Die Erfindung betrifft ein Verfahren zum zumindest bereichsweisen Einebnen einer Textur an Halbleiterstruktur (1), welche Halbleiterstruktur eine photovoltaische Solarzelle oder eine Vorstufe im Herstellungsprozess einer photovoltaischen Solarzelle ist, folgende Verfahrensschritte umfassend:
A. Erzeugen einer Textur auf einer ersten, bei Benutzung der Solarzelle der einfallenden Strahlung zugewandten Seite (2) und auf einer der ersten Seite gegenüberliegenden zweiten Seite (3) der Halbleiterstruktur;
B. Entfernen der Textur durch Einebnen der zweiten Seite (3) in einem Einebnungsbereich, welcher Einebnungsbereich zumindest ein Teilbereich der zweiten Seite ist;

welches dadurch gekennzeichnet ist, dass in Verfahrensschritt B das Einebnen durch Aufschmelzen zumindest des Einebnungsbereiches erfolgt.

## Beschreibung

Die Erfindung betrifft ein Verfahren zum zumindest bereichsweisen Einebnen einer Textur an Halbleiterstruktur, welche Halbleiterstruktur eine photovoltaische Solarzelle oder eine Vorstufe im Herstellungsprozess einer photovoltaischen Solarzelle ist.

Photovoltaische Solarzellen werden zur Umwandlung einfallender elektromagnetischer Strahlung in elektrischer Energie verwendet. Um den Wirkungsgrad solcher Solarzellen zu erhöhen, ist es bekannt, eine Textur an einer Seite der Solarzelle auszubilden, typischerweise an der bei Benutzung der einfallenden elektromagnetischen Strahlung zugewandten Seite der Solarzelle.

Eine solche Textur erhöht die Lichtausbeute. So kann ein auf die Oberfläche der Solarzelle auftreffendes Photon, welches reflektiert wird, aufgrund der Textur ein oder mehrmals auf weitere Oberflächen auftreffen, sodass sich die Einkoppelwahrscheinlichkeit erhöht. Weiterhin können Lichtstrahlen aufgrund der Textur abgelenkt werden, sodass der Strahlengang beispielsweise bei senkrecht auf die Solarzelle auftreffenden Lichtstrahlen innerhalb der Solarzelle schräg zur Vorderseite verläuft, sodass sich - insbesondere bei längerweiligen Strahlen - der Strahlenweg innerhalb der Solarzelle verlängert und hierdurch die Absorptionswahrscheinlichkeit erhöht wird und/oder die Wahrscheinlichkeit einer Reflektion an der Rückseite erhöht wird.

Zur Herstellung der Textur finden häufig Verfahren Anwendung, die beidseitig, das heißt auf einer Vorderseite und einer Rückseite eine Textur erzeugen. Insbesondere ist es bei Verwendung von mono- oder multikristallinen Siliziumwafern in einfacher Weise durch Eintauchen in entsprechende Ätzflüssigkeiten möglich, eine beidseitige Textur zu erstellen, so genannte "Random Pyramids".

An der Rückseite, d. h. der bei Benutzung dem Lichteinfall abgewandten Seite der Solarzelle, ist es jedoch vorteilhaft, eine plane Oberfläche auszubilden, wie beispielsweise in Mack, S., et al., in Proceedings of the 35th IEEE Photovoltaic Specialists Conference. 2010. Honolulu, Hawaii, USA, beschrieben. Die Vorteile sind insbesondere dann begründet, dass die Sättigungsstromdichte der Rückseite bei planer Ausbildung verringert wird und eine bessere Verspiegelung, d. h. ein höherer Reflexionsgrad für innerhalb der Solarzelle zur Rückseite gelangende Lichtstrahlen bei planer Rückseite erzielt werden kann, insbesondere, wenn an der Rückseite der Solarzelle ein Schichtstapel bestehend aus einer dielektrischen Sicht und einer metallischen Sicht ausgebildet wird.

Es ist daher bekannt, beidseitig nasschemisch eine plane Oberfläche zu erzeugen, anschließend auf der rückseitigen Oberfläche eine Ätzbarriere aufzubringen und eine nasschemische Texturierung durchzuführen, welche somit aufgrund der Ätzbarriere nur an der Vorderseite zu einer Texturierung führt. Ein solcher Prozess ist beispielsweise in Schultz, O., et al. in Proceedings of the 22nd European Photovoltaic Solar Energy Conference. 2007. Milan, Italy.

Die vorliegende Erfindung betrifft eine Alternative zu diesem Verfahren, bei welchem die Halbleiterstruktur aus welcher die Solarzelle ausgebildet werden soll, zunächst auf Vorder- und Rückseite nasschemisch texturiert wird und anschließend einseitig eine plane Oberfläche durch Entfernen der Texturierung erzeugt wird. Hier ist es bekannt, nasschemisch die Textur zu entfernen, um eine plane Oberfläche zu erzielen. Ein solches Verfahren ist beispielsweise in Mack, S., et al., in Proceedings of the 35th IEEE Photovoltaic Specialists Conference. 2010. Honolulu, Hawaii, USA, beschrieben.

Nachteilig ist bei beiden Verfahren, dass zur Planarisierung der Oberfläche Halbleitermaterial, d. h. typischerweise Silizium entfernt wird und in dem nasschemischen Ätzschritt somit verloren geht. Dies ist nachteilig, da die Herstellung von hochreinem, solarzellentauglichem Halbleitermaterial, insbesondere von hochreinem Silizium kostenintensiv ist und ein Materialverlust somit unerwünscht ist.

Der Erfindung liegt daher die Aufgabe zugrunde, ein Verfahren bereitzustellen, um eine einseitige Texturierung an einer Halbleiterstruktur, welche Halbleiterstruktur ein photovoltaische Solarzelle oder einer Vorstufe im Herstellungsprozess einer photovoltaischen Solarzelle ist, zu erzeugen. Hierbei soll der Materialverlust gegenüber vorbekannten Verfahren verringert werden und dennoch eine plane Oberfläche mit guten optischen und/oder elektrischen Eigenschaften erzielt werden.

Gelöst ist diese Aufgabe durch ein Verfahren gemäß Anspruch 1. Vorteilhafte Ausgestaltungen des erfindungsgemäßen Verfahrens finden sich in den Ansprüchen 2 bis 15. Hiermit wird der Wortlaut sämtlicher Ansprüche explizit per Referenz in die Beschreibung einbezogen.

Das erfindungsgemäße Verfahren zum zumindest bereichsweisen Einebnen einer Textur an Halbleiterstruktur umfasst folgende Verfahrensschritte: In einem Verfahrensschritt A erfolgt beim Erzeugen einer Textur auf einer ersten, bei Benutzung der Solarzelle der einfallenden Strahlung zugewandten Seite und auf einer der ersten Seite der gegenüberliegenden zweiten Seite der Halbleiterstruktur.

Die Halbleiterstruktur ist hierbei eine photovoltaische Solarzelle oder eine Vorstufe im Herstellungsprozess einer photovoltaischen Solarzelle. Beispielsweise kann die Halbleiterstruktur als Siliziumwafer oder als Schichtsystem aus mehreren Halbleiterschichten ausgebildet sein.

In einem Verfahrensschritt B erfolgt ein Entfernen der Textur durch Einebnen der zweiten Seite in einem Einebnungsbereich, welcher Einebnungsbereich zumindest ein Teilbereich der zweiten Seite ist. Bevorzugt überdeckt der Einebnungsbereich die gesamte zweite Seite.

Wesentlich ist, dass in Verfahrensschritt B das Einebnen durch Aufschmelzen zumindest des Einebnungsbereiches erfolgt.

Im Gegensatz zu vorbekannten Verfahren, bei welchen nach beidseitigem Erzeugen der Textur einseitig nasschemisch ein Abätzen der Textur zur Planarisierung der Oberfläche erfolgt, bei dem erfindungsgemäßen Verfahren somit ein oberflächennaher Bereich an der zweiten Seite aufgeschmolzen.

Durch das Aufschmelzen und den anschließenden Erstarrungsvorgang entsteht eine plane Oberfläche an der zweiten Seite der Halbleiterstruktur. Ein wesentlicher Unterschied zum vorbekannten Verfahren ist, dass in Verfahrensschritt B kein Materialabtrag erfolgt, da durch das Aufschmelzen und Erstarren des Materials der Halbleiterstruktur an der zweiten Seite kein Materialverlust auftritt.

Hierdurch ist ein Kostenvorteil gegenüber den vorbekannten Verfahren gegeben. Darüber hinaus bildet sich typischerweise beim Erstarren an der zweiten Seite nach dem Aufschmelzen eine hochwertige Kristallstruktur an der zweiten Seite der Halbleiterstruktur aus, sodass auch hinsichtlich der elektrischen Eigenschaften eine hochwertige plane Oberfläche an der zweiten Seite erzeugt wird.

Weiterhin ist das Aufschmelzen in einfacher Weise durch Beaufschlagen der zweiten Seite der Halbleiterstruktur mit Wärme durchführbar, sodass im Vergleich zu vorbekannten nasschemischen Planarisierungsprozessen ein weniger aufwändiges und damit kostengünstigeres Verfahren vorliegt.

Vorzugsweise erfolgt in Verfahrensschritt B das Aufschmelzen mit einer Aufschmelztiefe, welches zumindest die Höhe der in Verfahrensschritt A auf der zweiten Seite erzeugten Textur aufweist. Hierdurch ist sichergestellt, dass eine vollständige Planarisierung an der zweiten Seite in Verfahrensschritt B erfolgt. Die Aufschmelztiefe steht hierbei senkrecht zur zweiten Seite der Halbleiterstruktur und beschreibt den Abstand von der Oberfläche der Halbleiterstruktur an der zweiten Seite, den maximalen Abstand in welchem in Verfahrensschritt B die Halbleiterstruktur und das Material der Halbleiterstruktur aufgeschmolzen wird.

Vorzugsweise erfolgt in Verfahrensschritt B ein Aufschmelzen mit einer Aufschmelztiefe im Bereich 1 µm bis 30 µm, bevorzugt 5 µm bis 20 µm.

In bevorzugter Weise erfolgt in Verfahrensschritt B das Aufschlagen des zumindest Einebnungsbereiches mit Strahlung einer Lichtquelle, vorzugsweise eines Lasers. Hierdurch kann in einfacher Weise der Einebnungsbereich mit Wärme beaufschlagt und das Material der Halbleiterstruktur an der zweiten Seite aufgeschmolzen werden. Vorzugsweise erfolgt die Beaufschlagung mit Strahlung, welche eine Absorptionslänge in der Halbleiterstruktur > 1 µm, bevorzugt im Bereich 1 µm bis 30 µm, insbesondere im Bereich 5 µm bis 20 µm aufweist. Die Dauer der Beaufschlagung mit Strahlung ist so gewählt, dass die Wärmediffusionslänge in einer ähnlichen Größenordnung liegt wie die Aufschmelztiefe, welche in einem Bereich von 1 µm bis 30 µm liegt, insbesondere im Bereich 5 µm bis 20 µm. Hierdurch ergibt sich der Vorteil, dass zumindest der wesentliche Anteil der Strahlung in dem relevanten, an der zweiten Seite der Halbleiterstruktur oberflächennahen Bereich absorbiert wird und entsprechend die Wärmebeaufschlagung im Wesentlichen in diesem Bereich erfolgt.

Eine besonders einfache Ausgestaltung ergibt sich hierbei, indem der Einebnungsbereich sukzessive mit Strahlung beaufschlagt wird, vorzugsweise, indem die Lichtquelle einen länglichen, bevorzugt etwa rechteckigen Strahlquerschnitt aufweist und der Strahl der Lichtquelle in etwa senkrecht zu der Längserstreckung des Strahlquerschnitts über den Einebnungsbereich bewegt wird.

Insbesondere ist es vorteilhaft, dass der Strahlquerschnitt in seiner Längserstreckung den Einebnungsbereich vollständig überdeckt. Hierdurch kann in einfacher Weise und mit einer einfachen geradlinigen Relativbewegung zwischen Lichtstrahl und Halbleiterstruktur das Aufschmelzen erfolgen.

Es liegt hierbei im Rahmen der Erfindung, den Lichtstrahl der Lichtquelle mittels an sich bekannter optischer Systeme, wie beispielsweise Ablenkspiegeln über den Einebnungsbereich zu bewegen und/oder bei örtlich feststehendem Lichtstrahl die Halbleiterstruktur an dem Lichtstrahl vorbei zu bewegen.

Vorzugsweise erfolgt zwischen Verfahrensschritt A und Verfahrensschritt B in einem Verfahrensschritt AS ein Spülen zumindest der ersten, bevorzugt zumindest der ersten und der zweiten Seite der Halbleiterstruktur. Das Spülen erfolgt vorzugsweise mit DI-Wasser. Nach dem Spülen wird bevorzugt verbleibendes DI-Wasser in Verfahrensschritt B durch Erwärmen der Halbleiterstruktur entfernt.

Der Spülschritt AS zwischen Verfahrensschritt A und Verfahrensschritt B beseitigt auf der Oberfläche verbleibende Reste der Ätzlösung von Verfahrensschritt A. Am Ende des Spülvorgangs muss die Spülflüssigkeit, vorzugsweise DI-Wasser, getrocknet, bzw. entfernt werden. Besonders vorteilhaft hierbei ist, dass "automatisch", d. h. ohne dass ein zusätzlicher Verfahrensschritt hierfür notwendig ist, in Verfahrensschritt B aufgrund der Wärmeeinwirkung eine verwendete Spülflüssigkeit, insbesondere DI-Wasser entfernt wird, insbesondere verdunstet oder verdampft.

Vorzugsweise wird in Verfahrensschritt A die Textur nasschemisch, insbesondere bevorzugt mittels nasschemischen Ätzens erzeugt.

Hierbei kann zum nasschemischen Erzeugen der Textur auf an sich bekannte Prozessschritte zurückgegriffen werden. Insbesondere ist es vorteilhaft, anschließend an das nasschemische Ätzen den vorgenannten Spülschritt AS anzufügen, um eventuell verbleibende nasschemische Stoffe, insbesondere Ätzflüssigkeit zu entfernen.

In einer weiteren bevorzugten Ausführungsform des erfindungsgemäßen Verfahrens wird zwischen Verfahrensschritt A und Verfahrensschritt B in einem Verfahrensschritt AD eine Dotierschicht auf die zweite Seite aufgebracht, welche Dotierschicht ein Dotierstoff des n-Dotierungstyps oder des (hierzu entgegengesetzten) p-Dotierungstyps enthält. Hierdurch wird in einfacher Weise in Verfahrensschritt B bei dem Aufschmelzvorgang Dotierstoff aus der Dotierschicht in das aufgeschmolzene Material eingebracht und nach dem Erstarren liegt somit an der zweiten Seite ein oberflächennaher dotierter Bereich vor.

Insbesondere ist es vorteilhaft, dass die Halbleiterstruktur eine Basisdotierung eines Basisdotierungstyps aufweist und der Dotierstoff ebenfalls den Basisdotierungstyp aufweist.

Hierdurch wird in einfacher Weise in Verfahrensschritt B ein Hochdotierungsbereich des Basisdotierungstyps an der Rückseite ausgebildet, ein sogenanntes BSF ("Back Surface Field"), welches insbesondere zu einer Verringerung der Oberflächenrekombinationsgeschwindigkeit der Minoritätsladungsträger an der Rückseite führt und somit die elektronische Güte der Halbleiterstruktur und damit den Wirkungsgrad der Solarzelle erhöht.

Das Vorsehen eines BSF ist an sich bekannt und wird in der vorgenannten vorteilhaften Ausführungsform des erfindungsgemäßen Verfahrens somit in einfacher und kostengünstiger Weise ausgebildet.

In einer weiteren vorteilhaften Ausführung kann die im Schritt AD aufgebrachte Dotierschicht die dem Basisdotierungstyp entgegengesetzen Dotierungstyp enthalten.

Hierdurch wird in einfacher Weise in Verfahrensschritt B ein Hochdotierungsbereich entgegen des Basisdotierungstyps an der Rückseite ausgebildet, ein sogenannter Emitter. Die Herstellung rückseitig liegender Emitter ist an sich bekannt und beispielsweise beschrieben in Rauer, M. et al., in Proceedings of the 24th EU PVSEC 2009. Hamburg, Germany, p. 1059

Die Dotierschicht ist bevorzugt eine Schicht aus der Gruppe amorphe Siliziumschicht, dielektrische Schicht, Flüssigdotierstoffschicht oder Glasschicht, insbesondere bevorzugt Silikatglasschicht.

Diese Schichten weisen den Vorteil auf, dass diese Schichten mit an sich bekannten Verfahren aufgebracht werden.

Vorzugsweise wird zwischen Verfahrensschritt AD und Verfahrensschritt B in einem Verfahrensschritt ADE eine Emitterdiffusion an der ersten Seite der Halbleiterstruktur. In Verfahrensschritt ADE erfolgt somit ein Dotieren der ersten Seite mittels eines Dotierstoffes aus der Gasphase oder einer abgeschiedenen Dotierstoffquelle, beispielsweise ein als Film aufgebrachter Flüssigdotierstoff oder eine Dotierschicht, insbesondere eine mittels CVD/PVD (chemical vapour depostion / physical vapour deposition) aufgebrachte Dotierschicht. Hierbei kann auf grundsätzlich bekannte Prozessschritte zurückgegriffen werden. Vorteilhaft hierbei ist, dass die Dotierschicht AD als Diffusionsbarriere an der zweiten Seite wirkt und somit gewährleistet ist, dass der Emitter lediglich auf der ersten Seite, typischerweise die bei Benutzung der Solarzelle dem Lichteinfall zugewandte Seite, ausgebildet wird.

In dieser vorzugsweisen Ausführungsform wird somit in einfacher und kostengünstiger Weise an der ersten Seite in Verfahrensschritt ADE ein Emitter mit einem Emitterdotierungstyp, welcher dem Basisdotierungstyp entgegengesetzt ist, ausgebildet und in Verfahrensschritt AD eine Dotierschicht aufgebracht, welche - wie zuvor beschrieben - in Verfahrensschritt B zum Ausbilden eines BSF an der zweiten Seite der Halbleiterstruktur führt.

In einer weiteren vorzugsweisen Ausführung wird zwischen Verfahrensschritt AD und Verfahrensschritt B in einem Verfahrensschritt ADE eine Vorderseitenfeld (Front-Surface Field) -Diffusion an der ersten Seite der Halbleiterstruktur durchgeführt. Dabei wird an der ersten Seite des Halbleitersubstrates eine Dotierung der mit der Basisdotierung gleichen Dotierungstyp eindiffundiert. Die Ausbildung eines Front-Surface-Fields ist an sich bekannt und beispielsweise in Book, F. et al., in Energy Procedia Vol. 8 (2011) p. 1876 beschrieben. In Verfahrensschritt ADE erfolgt somit ein Dotieren der ersten Seite mittels eines Dotierstoffes aus der Gasphase oder einer abgeschiedenen Dotierstoffquelle, beispielsweise ein als Film aufgebrachter Flüssigdotierstoff oder eine Dotierschicht, insbesondere eine mittels CVD/PVD (chemical vapour depostion / physical vapour deposition) aufgebrachte Dotierschicht. Hierbei kann auf grundsätzlich bekannte Prozessschritte zurückgegriffen werden. Vorteilhaft hierbei ist, dass die Dotierschicht AD als Diffusionsbarriere an der zweiten Seite wirkt und somit gewährleistet ist, dass das Front-Surface-Field lediglich auf der ersten Seite, typischerweise die bei Benutzung der Solarzelle dem Lichteinfall zugewandte Seite, ausgebildet wird.

In dieser vorzugsweisen Ausführungsform wird somit in einfacher und kostengünstiger Weise an der ersten Seite in Verfahrensschritt ADE ein Front-Surface-Field mit einem Dotierungstyp, welcher dem Basisdotierungstyp gleich ist, ausgebildet und in Verfahrensschritt AD eine Dotierschicht aufgebracht, welche - wie zuvor beschrieben - in Verfahrensschritt B zum Ausbilden eines Emitters an der zweiten Seite der Halbleiterstruktur führt.

In einer weiteren, vorzugsweisen Ausführung des Verfahrens wird der Verfahrensschritt ADE nach Verfahrensschritt B ausgeführt. Wie bereits beschrieben, verbleibt die Dotierschicht AD nach Verfahrensschritt B auf dem Wafer und wirkt als Diffusionsbarriere für die Emitterdiffusion ADE oder Front-Surface Field-Diffusion ADE. Bei dieser Ausführung erfolgt ein Dotieren im Schritt ADE der ersten Seite mittels eines Dotierstoffes aus der Gasphase oder einer abgeschiedenen Dotierstoffquelle. Hierbei kann auf grundsätzlich bekannte Prozessschritte zurückgegriffen werden.

Vorzugsweise wird hierbei in Verfahrensschritt AD als Dotierschicht eine dielektrische Schicht, bevorzugt eine Glasschicht, weiterhin bevorzugt eine Silikatglasschicht, insbesondere bevorzugt eine Borglasschicht als Quelle für p-Dotierung aufgebracht, da diese besonders als Diffusionsbarriere gegenüber dem Dotierstoff des Emitterdotierungstyps geeignet sind. Ebenso kann eine Quelle für eine n-Dotierung aufgebracht werden, insbesondere eine Phosphorglasschicht.

In einer weiteren vorzugsweisen Ausführungsform des erfindungsgemäßen Verfahrens wird zwischen Verfahrensschritt A und Verfahrensschritt B in einem Verfahrensschritt AE an der ersten und an der zweiten Seite der Halbleiterstruktur ein Emitter diffundiert, bevorzugt mittels Diffusion aus der Gasphase. Hierdurch wird in einfacher Weise ein beidseitiger Emitter ausgebildet, wobei nach Abschluss des Verfahrensschrittes B an der Vorderseite ein der Textur folgender Emitter ausgebildet ist und an der Rückseite aufgrund des Aufschmelzens und anschließenden Erstarrens ein Emitter an der planen zweiten Seite ausgebildet ist. Hierdurch kann in einfacher Weise ein beidseitiger Emitter für entsprechende Solarzellenstrukturen, wie beispielsweise rückseitig kontaktierte Solarzellen wie Rückseitenkontaktzellen, MWT- oder EWT-Solarzellen ausgebildet werden. Es liegt im Rahmen der Erfindung, durch den Diffusionsprozess ebenfalls ein Front-Surface Field auszubilden, welches eine gleiche Polarität der Dotierung aufweist wie die des Basissubstrats. Nach Abschluss des Verfahrensschrittes B ist an der Vorderseite ein der Textur folgendes Front Surface Field ausgebildet und an der Rückseite aufgrund des Aufschmelzens und anschließenden Erstarrens ein Back Surface Field an der planen zweiten Seite ausgebildet ist.

Um eine möglichst geringe Beeinträchtigung der Solarzelle durch Unebenheiten an der zweiten Seite zu erzielen, wird vorzugsweise in Verfahrensschritt B die gesamte Oberfläche der zweiten Seite aufgeschmolzen und eingeebnet.

Ebenso liegt es im Rahmen der Erfindung, Teilbereiche der zweiten Seite nicht aufzuschmelzen und einzuebnen. Dies kann darin begründet sein, dass die nicht eingeebneten Teilbereiche keinen negativen Effekt auf den Wirkungsgrad der Solarzelle bewirken oder dass positive Effekte durch lokale, nicht eingeebnete Bereiche erzielt werden, beispielsweise im Sinne von Positionsmarken für nachfolgendende Verfahrensschritte oder in Bereichen, in denen eine Kontaktierung mittels einer oder mehrerer metallischer Kontaktierungsstrukturen erfolgen soll, denn bei manchen Kontaktierungsarten kann eine unebene Oberfläche vorteilhaft sein. Vorzugsweise wird jedoch der überwiegende Flächenanteil der Oberfläche der zweiten Seite eingeebnet, um die Sättigungsstromdichte an der zweiten Seite zu verringern. In einer bevorzugten Ausführungsform werden daher zumindest 70%, bevorzugt mindestens 85%, weiter bevorzugt mindestens 90%, insbesondere mindestens 95% der Oberfläche der zweiten Seite aufgeschmolzen und eingeebnet.

In einer weiteren Ausführungsform des erfindungsgemäßen Verfahrens werden in Verfahrensschritt B Teilbereiche der zweiten Seite nicht aufgeschmolzen, in welchen Teilbereichen in nachfolgenden Verfahrensschritten metallische Kontaktierungsstrukturen zur elektrischen Kontaktierung der Halbleiterstruktur aufgebracht werden. Hierdurch ergibt sich der Vorteil, dass dadurch eine größere Oberfläche eine größere Kontaktfläche zwischen Metall und Halbleiter vorliegt..

In einer weiteren Ausführungsform werden in Verfahrensschritt B Teilbereiche der zweiten Seite nicht aufgeschmolzen, welche nicht aufgeschmolzenen Teilbereiche als Positioniermarken für ein optisches Positionserkennungssystem ausgebildet sind.

Hierdurch können somit in einfacher und kostengünstiger Weise Positioniermarken ausgebildet werden, denn die nicht aufgeschmolzenen Teilbereiche weisen entsprechend nach Abschluss des Verfahrensschrittes B weiterhin eine Textur auf und zeigen somit ein anderes Reflexionsverhalten gegenüber den in Verfahrensschritt B planarisierten Einebnungsbereichen. Hierdurch können die (mit einer Textur versehenen) nicht aufgeschmolzenen Teilbereiche mittels eines optischen Positionserkennungssystems von den planarisierten Einebnungsbereichen unterschieden werden.

Eine derartige Ausbildung von Positioniermarken, welche in einer Vielzahl von Herstellungsprozessen für Solarzellen zur Justierung notwendig sind, ist kostengünstiger verglichen der typischerweise mittels Ätzverfahren oder Laserablation hergestellten Positioniermarken. Darüber hinaus weisen die durch vorbekannte Verfahren hergestellten Positioniermarken typischerweise eine beschädigte Oberfläche der Halbleiterstruktur auf, sodass in diesen Bereichen eine erhöhte Ladungsträgerrekombination auftritt.

In der vorgenannten vorzugsweisen Ausführungsform des erfindungsgemäßen Verfahrens sind die Positioniermarken jedoch lediglich durch nicht planarisierte Bereiche ausgebildet, welche jedoch die Oberflächenqualität der texturierten Bereiche, d. h. beispielsweise die Oberflächenqualität der texturierten ersten Seite der Halbleiterstruktur aufweisen.

Das erfindungsgemäße Verfahren ist insbesondere zur Ausbildung einer PERT-Solarzelle geeignet. Vorzugsweise wird mittels des erfindungsgemäßen Verfahrens daher eine solche PERT-Solarzelle ausgebildet. Die Struktur einer PERT-Solarzelle ist an sich bekannt, und beispielsweise in Zhao, J. et al in Progress in Photovoltaics: Research and Applications, Vol. 7, pp. 471-4.beschrieben.

Ebenso ist das erfindungsgemäße Verfahren zur Ausbildung einer der Solarzellenstrukturen BCBJ-Solarzelle (beschrieben in Cousins, P., et al., in Proceedings of the 35th IEEE Photovoltaic Specialists Conference. 2010. Honolulu, Hawaii, USA), PERC-Solarzelle (beschrieben in Blakers et al., Applied Physics Letters, vol. 55 (1989) pp. 1363-5), PERL-Solarzelle (beschrieben in Zhao, J. et al in Progress in Photovoltaics: Research and Applications, Vol. 7, pp. 471-4) besonders geeignet.

Alternativ oder zusätzlich ist das Verfahren besonders zur Ausbildung von Solarzellen mit hinsichtlich der Ladungsträgerrekombination passivierten Oberflächen geeignet.

Bei dem erfindungsgemäßen Verfahren wird bevorzugt der Lichtstrahl einer Lichtquelle, insbesondere der fokussierte Lichtstrahl einer Lichtquelle, zum Aufschmelzen des Einebnungsbereiches verwendet. Insbesondere ein Laserstrahl ist zum Einbringen der notwendigen Energie zum oberflächennahen Aufschmelzen vorteilhaft in der Anwendung. Die Laserparameter (Wellenlänge, Pulslänge und geometrische Form des Strahls) werden bevorzugt derart gewählt, dass nur eine geringe oder keine Schädigung der Kristallstruktur der aufgeschmolzenen Halbleiterstruktur vorliegt.

Wie bereits ausgeführt, erfolgt das Aufschmelzen vorzugsweise mit einer Schmelztiefe 1 µm bis 30 µm, bevorzugt 5 µm bis 20 µm, das heißt das im Einebnungsbereich lediglich eine oberflächennahe Schicht mit einer Tiefe in dem zuvor genannten Bereich aufgeschmolzen wird. Ein derartiges oberflächennahes Aufschmelzen kann mit Lasersystemen verschiedener Wellen- und Pulslängen erreicht werden. Insbesondere ist die Anwendung von gepulsten Lasern vorteilhaft, bevorzugt mit einer Wellenlänge im Bereich von 150 nm bis 11000 nm. Die Pulslängen liegen vorzugsweise im Bereich von 1 ps bis zu mehreren Millisekunden (bevorzugt < 20 ms) in Abhängigkeit der gewählten Repetitionsrate.

Vorteilhaft sind Laser mit einer Wellenlänge von 515, 532, 780 bis 980, 1030 oder 1064 nm bei Pulslängen im Bereich von 0,05 bis 10000 µs.

Ebenso kann das erfindungsgemäße Verfahren mit einem Laser in DauerBetrieb ("cw", d. h. continuous waves) oder einem cw-Laser im modulierten Betrieb mit den beschriebenen Wellenlängen durchgeführt werden.

Es können insbesondere kommerziell erhältliche Lasersysteme mit Ausgangsleistungen mit den oben genannten Wellenlängen, Pulslängen und im DauerBetrieb bis einige Kilowatt bis zu einigen 10 kW Ausgangsleistungen angewendet werden.

Alternativ zu dem vorbeschriebenen Laser kann auch eine fokussierte Lichtquelle, insbesondere eine Weißlichtquelle, zum Einbringen der notwendigen Energie zum Aufschmelzen zumindest des Einebnungsbereiches verwendet werden. Die Fokussierung erfolgt hierbei vorzugsweise über Parabolspiegeln analog zu der Figur 4 und der entsprechenden Beschreibung in A. Eyer et. al. in Proceedings of the 19th European Photovoltaic Solar Energy Conference 2004, Paris, France, pp. 931-4.

Wie zuvor bereits ausgeführt, kann die Planarisierung zumindest des Einebnungsbereiches ganzflächig oder aber auch selektiv erfolgen, das heißt der Einebnungsbereich kann sich über die gesamte zweite Seite der Halbleiterstruktur oder auch nur über einen Teilbereich der zweiten Seite erstrecken. Ebenso liegt es im Rahmen der Erfindung, dass an der zweiten Seite mehrere Einebnungsbereiche mittels Aufschmelzen planarisiert werden. Vorzugsweise wird die räumliche Strahlformung des verwendeten Lichtstrahls der Breite und/oder Form des Einebnungsbereiches angepasst.

Es liegt im Rahmen der Erfindung, n- und/oder p-dotierte Halbleiterbereiche mittels Aufschmelzens zu planarisieren.

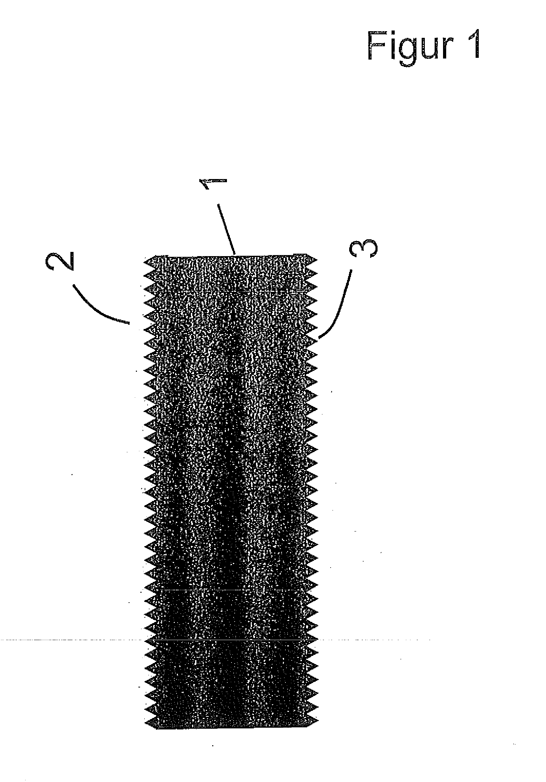

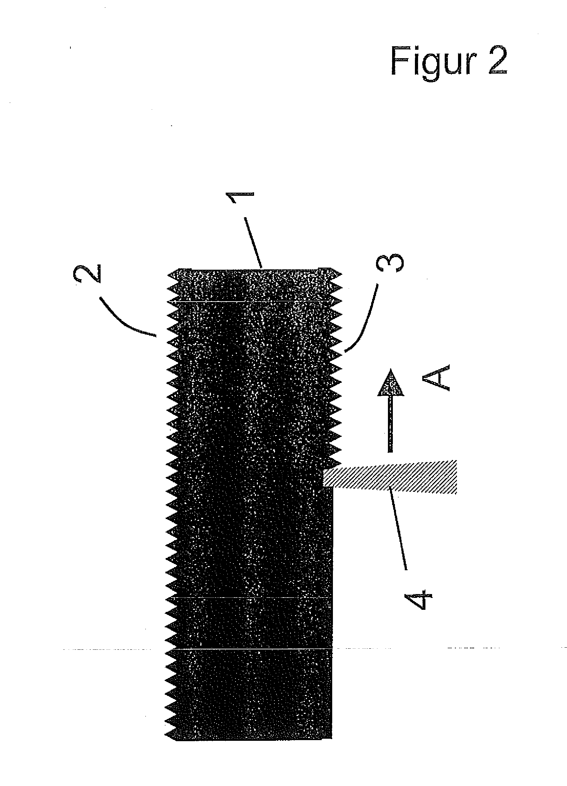

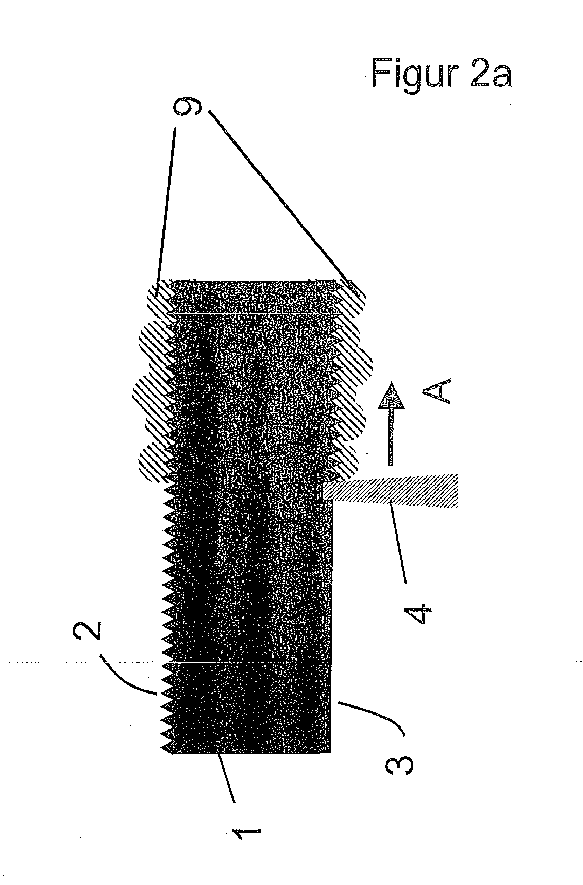

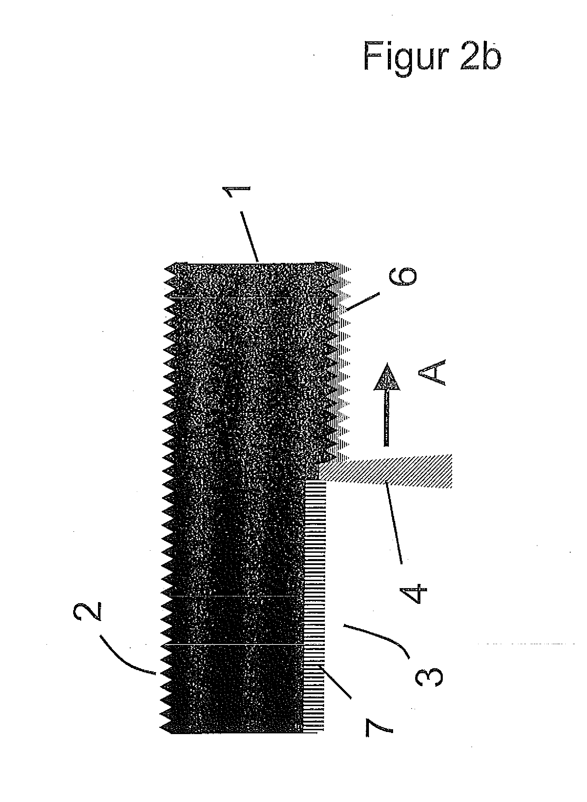

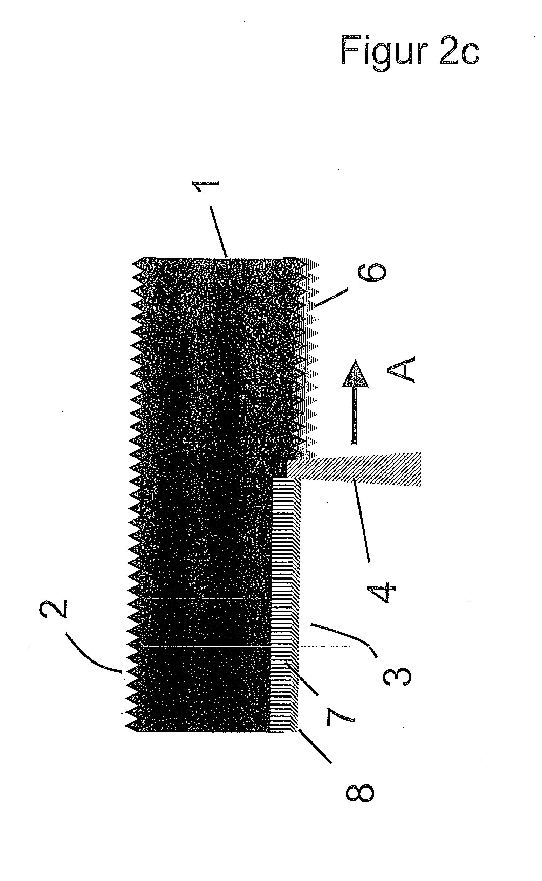

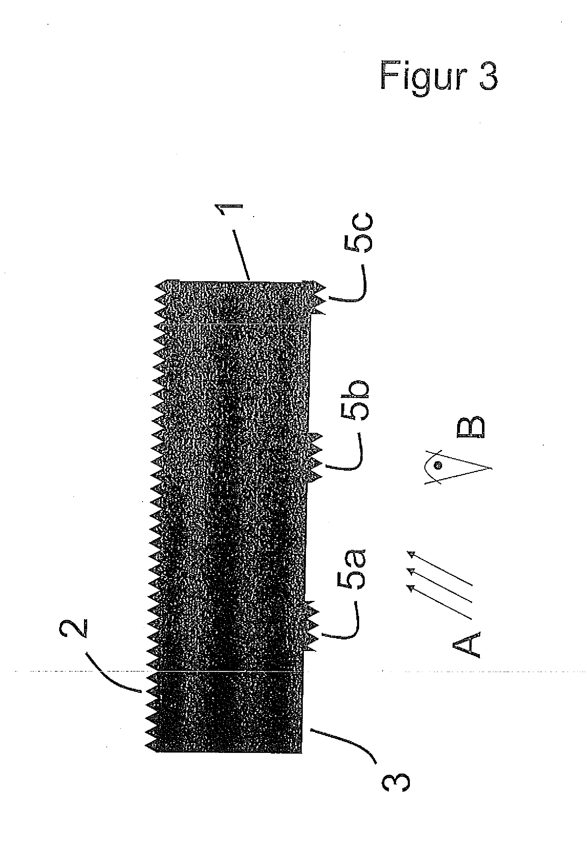

Weitere vorzugsweise Merkmale und Ausführungsformen des erfindungsgemäßen Verfahrens werden im Folgenden anhand der Figuren beschrieben. Die Figuren 1 - 3 zeigen drei Ausführungsbeispiele eines erfindungsgemäßen Verfahrens, wobei die Verfahrensschritte gemäß der Figuren 1 und 3 bei allen Ausführungsbeispielen gleich sind, lediglich hinsichtlich der in den Figuren 2, 2a, 2b und 2c dargestellten Verfahrensschritte unterscheiden sich die drei Ausführungsbeispiele:
Die Figuren zeigen schematische Schnittbilder einer zu bearbeitenden Halbleiterstruktur. In den Figuren bezeichnen gleiche Bezugszeichen gleiche oder gleichwirkende Elemente.

Die Figuren 1 bis 3 stellen schematische, nicht maßstabsgetreue Teilschnittbilder dar, wobei die jeweils dargestellte Halbleiterstruktur sich nach rechts und links analog fortsetzt.

Gemäß des ersten Ausführungsbeispiels des erfindungsgemäßen Verfahrens wird in einem Verfahrensschritt A eine Textur auf einer ersten, bei Benutzung der Solarzelle der einfallenden Strahlung zugewandten Seite und auf einer der ersten Seite gegenüberliegenden zweiten Seite einer Halbleiterstruktur ausgebildet. Der Zustand nach solch einem Verfahrensschritt A ist in Figur 1 dargestellt:
Eine Halbleiterstruktur 1 ist als monokristalliner, p-dotierter Siliziumwafer ausgebildet. Mittels eines nasschemischen Prozesses wird in an sich bekannter Weise an beiden Seiten eine Textur erzeugt, wobei in allen Figuren die erste, bei Benutzung der Solarzelle der einfallenden Strahlung zugewandte Seite oben und die zweite Seite unten dargestellt ist. Zur Texturierung wird die Halbleiterstruktur 1 in eine alkalische Lösung eingetaucht, welche Kaliumhydroxid (KOH) und einen oder mehrere Alkohole enthält.

In einem Verfahrensschritt B wird an der zweiten Seite 3 die Textur durch Einebnen der zweiten Seite 3 in einem Einebnungsbereich entfernt. Der Einebnungsbereich ist ein Teilbereich der zweiten Seite 3, er umfasst mit Ausnahme von mehreren Justierkreuzbereichen die gesamte Seite 3. Der Einebnungsbereich überdeckt somit die ganze Seite 3 und weist lediglich Aussparungen in Form von mehreren "+"-Symbolen auf.

Wesentlich ist, dass in diesem ersten Ausführungsbeispiel gemäß Figur 2 mittels eines (nicht dargestellten) Lasers ein Laserstrahl 4 auf die zweite Seite 3 fixiert wird und (angedeutet durch die Bewegungsrichtung A) mittels eines - nicht dargestellten - optischen Ablenkungssystems über die zweite Seite 3 hinweg bewegt wird, sodass der gesamte Einebnungsbereich derart mit Laserstrahlung beaufschlagt wird, dass ein Aufschmelzen der Halbleiterstruktur an der zweiten Seite mit einer Aufschmelztiefe von etwa 20 µm erfolgt. Die von der zweiten Seite 3 ausgebildete Textur weist eine Höhe im Bereich von etwa 15 µm auf, sodass nach Erstarren der jeweils mittels des Laserstrahls 4 lokal aufgeschmolzenen Bereiche eine planarisierte Oberfläche (in Figur 2 links des Laserstrahls A dargestellt) erzeugt wird.

Hierbei wird ein Laser mit folgenden Laserparametern verwendet: 532 nm und einer Pulslänge von 1000 ns.

Diese Laserparameter sind so gewählt, dass bei dem vorgenannten Schmelzprozess, das heißt dem oberflächennahen Aufschmelzen mittels des Laserstrahls, keine oder nur eine sehr geringe Verdampfung oder Ablation von Silizium in der Halbleiterstruktur 1 erfolgt. Das erfindungsgemäße Verfahren stellt somit einen Einebnungsprozess zur Verfügung, der kein oder nur einen sehr geringen Materialverlust aufweist und darüber hinaus kann in einfacher Weise durch Vorgabe der mittels des Laserstrahls beaufschlagten Bereiche der zweiten Seite 3 der Einebnungsbereich gewählt werden, in welchem die Planarisierung erfolgt.

In Figur 3 ist der Zustand nach Verfahrensschritt B dargestellt, das heißt nachdem an der zweiten Seite 3 die Oberfläche im Einebnungsbereich vollständig planarisiert wurde. Lediglich an lokalen Teilbereichen 5a, 5b, 5c, welche Justierkreuze darstellen, erfolgte keine Planarisierung. Bei der weiteren Prozessierung der Halbleiterstruktur 1 zur Herstellung einer photovoltaischen Solarzelle kann nun der Kontrastunterschied zwischen den planarisierten Bereichen und den nicht planarisierten Teilbereichen 5a, 5b und 5c zur Justierung verwendet werden:
Bei beispielsweise schräger Beleuchtung, wie durch die Pfeile A in Figur 3 angedeutet, kann ein Betrachter E, wie beispielsweise ein Kamerasystem, diesen Kontrastunterschied mit handelsüblichen Bildauswerteverfahren in einfacher und kostengünstiger Weise detektieren und so eine Justierung, insbesondere eine sogenannte "Allinierung", von Folgeprozessen durchgeführt werden. Bei Herstellungsverfahren im vorbekannten Stand der Technik ist es üblich, die Allinierung mittels Randerkennung, das heißt auf den Rand des Wafers bezogen, auszuführen. Dies führt jedoch insbesondere bei nicht rechtwinklig zueinanderstehenden Rändern zu Ungenauigkeiten. Das erfindungsgemäße Verfahren bietet somit darüber hinaus den Vorteil, dass in einfacher und kostengünstiger Weise an genau vorgebbaren Ortspositionen Justierkreuze ausgebildet werden können, die in einfacher Weise mittels handelsüblicher optischer Kamerasysteme örtlich detektiert und für eine Allinierung verwendet werden können.

Ein zweites Ausführungsbeispiel des erfindungsgemäßen Verfahrens weist hinsichtlich der Figuren 1 und 3 die gleichen, vorbeschriebenen Verfahrensschritte und Merkmale auf. Zur Vermeidung von Wiederholungen wird daher nachfolgend nur auf die Unterschiede eingegangen:
Im Unterschied zu dem ersten Ausführungsbeispiel gemäß Figur 2 wird bei dem zweiten Ausführungsbeispiel gemäß Figur 2a während der Planarisierung der zweiten Seite 3 in dem Einebnungsbereich mittels des Laserstrahls 4 deionisiertes Wasser 9 (DI- oder H₂O) getrocknet.

Dies ist darin begründet, dass nach Durchführen des nasschemischen Ätzvorgangs, wie zu Figur 1 beschrieben, ein Spülvorgang mittels deionisiertem Wasser erfolgte. Gemäß dem zweiten Ausführungsbeispiel ist es jedoch nicht notwendig, nach dem Spülvorgang auf der ersten Seite 2 und der zweiten Seite 3 der Halbleiterstruktur 1 verbleibendes deionisiertes Wasser zu trocknen. Denn aufgrund des Energiebeitrags durch den Laserstrahl 4 in die Halbleiterstruktur 1 erwärmt sich die Halbleiterstruktur auf oberhalb der Schmelztemperatur (T > 1410°C), sodass als vorteilhafter Nebeneffekt während des Planarisierungsvorganges aufgrund der Erwärmung das verbleibende deionisierte Wasser verdunstet oder verdampft. Gemäß diesem zweiten Ausführungsbeispiel kann somit ein sonst notwendiger Trocknungsprozess nach der nasschemischen Textur und Spülung eingespart werden.

Auch ein drittes Ausführungsbeispiel des erfindungsgemäßen Verfahrens unterscheidet sich lediglich hinsichtlich der Verfahrensschritte und Merkmale gemäß Figur 2 und weist hinsichtlich der Figuren 1 und 3 die gleichen Verfahrensschritte und Merkmale wie das erste und zweite Verfahrensbeispiel auf. Auch hier wird zur Vermeidung von Wiederholungen lediglich auf die Figur 2b eingegangen:
Im Unterschied zu dem ersten Ausführungsbeispiel gemäß Figur 2 wird bei dem dritten Ausführungsbeispiel gemäß Figur 2b in einem Verfahrensschritt AB zwischen Verfahrensschritt A und Verfahrensschritt B eine Dotierschicht 6 aufgebracht. Die Dotierschicht ist als Borsilikatglas ausgebildet, welches als Dotiermittel des p-Dotierungstyps Bor enthält.

Während des Aufschmelzvorgangs erfolgt somit ein Eintreiben des Dotiermittels bzw. eine Diffusion in der kurzzeitig vorliegenden Flüssigphase, sodass nach Erstarren des oberflächennahen Bereichs eine hochdotierte, oberflächennahe Schicht des p-Dotierungstypes entsteht, ein sogenanntes BSF (Back Surface Field). Dieses BSF 7 ist in Figur 2b entsprechend in dem bereits planarisierten Bereich links des Laserstrahls 4 dargestellt.

Bei diesem dritten Ausführungsbeispiel wird somit in einfacher Weise als "Nebeneffekt" ein an sich bekanntes BSF 7 erzeugt, welches insbesondere zur Verringerung der Oberflächenrekombinationsgeschwindigkeit für Minoritätsladungsträger an der zweiten Seite 3 dient und somit den Wirkungsgrad der herzustellenden photovoltaischen Solarzelle steigert.

In einer Weiterbildung des dritten Ausführungsbeispiels wird anstelle des Borsilikatglases ein Dielektrikum, welches einen Dotierstoff enthält, als Dotierschicht 6 verwendet. Hierdurch ergibt sich der Vorteil, dass auch nach dem Aufschmelzvorgang zwar Dotierstoff aus der Dotierschicht 6 in die Halbleiterstruktur eingetrieben bzw. eindiffundiert wurde, dass jedoch auch nach Planarisierung in dem planarisierten Bereich das Dielektrikum auf der Oberfläche der zweiten Seite 3 verbleibt. Dies ist darin begründet, dass das Dielektrikum beim Verfahrensschritt B nicht ablatiert wird. Dies ist in der Figur 2c mit dem Dielektrikum 8 dargestellt.

Bei dieser Weiterbildung des dritten Ausführungsbeispiels wird somit in einfacher und kostengünstiger Weise zusätzlich zur Erzeugung des BSF eine dielektrische Oberflächen passivierende Schicht aufgebracht, welche ebenfalls wie zuvor beschrieben die Oberflächenrekombinationsgeschwindigkeit an der zweiten Seite 3 der Halbleiterstruktur 1 senkt.

Weiterhin oder alternativ dient die dielektrische Schicht als Diffusionsbarriere für eine nachfolgende Emitterdiffusion:
In einer weiteren Weiterbildung des dritten Ausführungsbeispiels wird nach Abschluss des in Figur 2c dargestellten Verfahrensschrittes eine Emitterdiffusion aus der Gasphase in an sich bekannter Weise durchgeführt, das heißt es wird ein Dotierstoff eines zu der Basis entgegengesetzten Dotierungstyps, vorliegend ein Dotierstoff des n-Dotierungstyps, in oberflächennahe Bereiche der Halbleiterstruktur 1 eingetrieben. Da die zweite Seite 3 jedoch mit der dielektrischen Schicht 8 bedeckt ist, dient dies als Diffusionsbarriere, sodass sich ausschließlich von der ersten Seite 2 der Halbleiterstruktur 1 ein Emitter ausbildet. Hierdurch wird in kostengünstiger Weise eine an sich bekannte, typische Solarzellenstruktur ausgebildet, bei welcher lediglich an der bei Benutzung der einfallenden Strahlung zugewandten Vorderseite, das heißt ersten Seite 2 der Halbleiterstruktur 1, ein Emitter ausgebildet wird.

## Patentansprüche

1. Verfahren zum zumindest bereichsweisen Einebnen einer Textur einer Halbleiterstruktur (1), welche Halbleiterstruktur (1) eine photovoltaische Solarzelle oder eine Vorstufe im Herstellungsprozess einer photovoltaischen Solarzelle ist, folgende Verfahrensschritte umfassend:
A. Erzeugen einer Textur auf einer ersten, bei Benutzung der Solarzelle der einfallenden Strahlung zugewandten Seite und auf einer der ersten Seite (2) gegenüberliegenden zweiten Seite (3) der Halbleiterstruktur (1);
B. Entfernen der Textur durch Einebnen der zweiten Seite (3) in einem Einebnungsbereich, welcher Einebnungsbereich zumindest ein Teilbereich der zweiten Seite (3) ist;
**dadurch gekennzeichnet,**
**dass** in Verfahrensschritt B das Einebnen durch Aufschmelzen zumindest des Einebnungsbereiches erfolgt.

2. Verfahren nach Anspruch 1,
**dadurch gekennzeichnet,**
**dass** in Verfahrensschritt B das Aufschmelzen mit einer Aufschmelztiefe erfolgt, welche zumindest die Höhe der in Verfahrensschritt A auf der zweiten Seite (3) erzeugten Textur aufweist, bevorzugt mit einer Aufschmelztiefe im Bereich 1 µm bis 30 µm.

3. Verfahren nach einem der vorangegangenen Ansprüche,
**dadurch gekennzeichnet,**
**dass** das Aufschmelzen in Verfahrensschritt B durch Beaufschlagen des Einebnungsbereiches mit Strahlung einer Lichtquelle, vorzugsweise eines Lasers, erfolgt.

4. Verfahren nach einem Anspruch 3,
**dadurch gekennzeichnet,**
**dass** der Einebnungsbereich sukzessive mit Strahlung beaufschlagt wird, vorzugsweise, dass die die Lichtquelle einen länglichen, bevorzugt etwa rechteckigen Strahlquerschnitt aufweist und der Strahl der Lichtquelle in etwa senkrecht zu der Längserstreckung des Strahlquerschnitts über den Einebnungsbereich bewegt wird, insbesondere, dass der Strahlquerschnitt in seiner Längserstreckung den Einebnungsbereich vollständig überdeckt.

5. Verfahren nach einem der vorangegangenen Ansprüche,
**dadurch gekennzeichnet,**
**dass** zwischen Verfahrensschritt A und Verfahrensschritt B in einem Verfahrensschritt AS ein Spülen zumindest der ersten, bevorzugt zumindest der ersten und der zweiten Seite (3) erfolgt, vorzugsweise mit DI-Wasser, und dass nach dem Spülen verbleibende Spülflüssigkeit, insbesondere DI-Wasser (9) in Verfahrensschritt B durch Erwärmen der Halbleiterstruktur (1), welches Erwärmen bei dem Aufschmelzvorgang erfolgt, entfernt wird.

6. Verfahren nach Anspruch 5,
**dadurch gekennzeichnet,**
**dass** in Verfahrensschritt A die Textur nasschemisch, vorzugsweise mittels Ätzen erzeugt wird.

7. Verfahren nach einem der vorangegangenen Ansprüche,
**dadurch gekennzeichnet,**
**dass** zwischen Verfahrensschritt A und Verfahrensschritt B in einem Verfahrensschritt AD eine Dotierschicht (6) auf die zweite Seite (3) aufgebracht wird, welche Dotierschicht (6) einen Dotierstoff des n-Dotierungstyps oder des p-Dotierungstyps enthält, vorzugsweise, dass der Dotierstoff den Dotierungstyp einer Basisdotierung der Halbleiterstruktur (1) aufweist.

8. Verfahren nach Anspruch 7,
**dadurch gekennzeichnet,**
**dass** Dotierschicht (6) eine Schicht aus der Gruppe amorphe Siliziumschicht, dielektrische Schicht, Flüssigdotierstoffschicht oder Glasschicht, insbesondere Silikatglasschicht ist.

9. Verfahren nach einem der Ansprüche 7 bis 8,
**dadurch gekennzeichnet,**
**dass** zwischen Verfahrensschritt AD und Verfahrensschritt B in einem Verfahrensschritt ADE eine Diffusion, insbesondere zur Ausbildung eines Emitters oder eines Front-Surface-Fields, an der ersten Seite (2) der Halbleiterstruktur (1) aus der Gasphase oder einer abgeschiedenen Dotierstoffquelle erfolgt, vorzugsweise, dass in Verfahrensschritt AD eine Glasschicht, vorzugsweise eine Silikatglasschicht, insbesondere eine Borglasschicht oder Phosphorglasschicht als Dotierschicht (6) aufgebracht wird.

10. Verfahren nach einem der Ansprüche 7 bis 8,
**dadurch gekennzeichnet,**
**dass** nach Verfahrensschritt B in einem Verfahrensschritt ADE eine Diffusion, insbesondere zur Ausbildung eines Emitters oder eines Front-Surface-Fields, an der ersten Seite (2) der Halbleiterstruktur (1) aus der Gasphase oder einer abgeschiedenen Dotierstoffquelle erfolgt, vorzugsweise, dass in Verfahrensschritt AD eine Glasschicht, vorzugsweise eine Silikatglasschicht, insbesondere eine Borglasschicht oder Phosphorglasschicht als Dotierschicht (6) aufgebracht wird.

11. Verfahren nach einem der vorangegangenen Ansprüche,
**dadurch gekennzeichnet,**
**dass** zwischen Verfahrensschritt A und B in einem Verfahrensschritt AE an der ersten und an der zweiten Seite (3) der Halbleiterstruktur (1) ein Emitter oder ein Front-Surface-Field eindiffundiert wird, vorzugsweise mittels Diffusion aus der Gasphase.

12. Verfahren nach einem der vorangegangenen Ansprüche,
**dadurch gekennzeichnet,**
**dass** die Verfahrensschritt B zumindest 70%, bevorzugt mindestens 85%, weiter bevorzugt mindestens 90%, insbesondere mindestens 95%, besonders bevorzugt die gesamte Oberfläche der zweiten Seite (3) aufgeschmolzen wird.

13. Verfahren nach einem der vorangegangenen Ansprüche 1 bis 11,
**dadurch gekennzeichnet,**
**dass** in Verfahrensschritt B Teilbereiche der zweiten Seite (3) nicht aufgeschmolzen werden, welche nach Verfahrensschritt B einen Kontrastunterschied zu den eingeebneten Bereichen aufweisen.

14. Verfahren nach einem der vorangegangenen Ansprüche 1 bis 11,
**dadurch gekennzeichnet,**
**dass** in Verfahrensschritt B Teilbereiche der zweiten Seite (3) nicht aufgeschmolzen werden, welche nicht aufgeschmolzenen Teilbereiche als Positioniermarken für ein optisches Positionserkennungssystem ausgebildet sind.

15. Verfahren nach einem der vorangegangenen Ansprüche,
**dadurch gekennzeichnet,**
**dass** die photovoltaische Solarzelle eine Solarzelle aus der Gruppe PERT-Solarzelle, BCBJ-Solarzelle, PERC-Solarzelle, PERL-Solarzelle und/oder eine Solarzelle mit hinsichtlich der Ladungsträgerrekombination passivierten Oberflächen ist.
